# EUROPEAN PATENT APPLICATION

(11) **EP 2 302 989 A2**
(43) Date of publication of application: **30.03.2011**
(21) Application number: 10175537.9
(22) Date of filing: 07.09.2010
(51) Int. Cl.: H05K 7/14

(54) **Substrate holding apparatus**

(30) Priority: 25.09.2009 JP 2009221361
(71) Applicant: AISIN SEIKI KABUSHIKI KAISHA, Kariya-shi, Aichi 448-8650 (JP)
(72) Inventor: Saiki, Shunsuke, Kariya-shi Aichi 448-8650 (JP); Naito, Takeshi, Kariya-shi Aichi 448-8650 (JP); Asano, Tadashi, Kariya-shi Aichi 448-8650 (JP)
(74) Representative: TBK-Patent

(57) **Abstract**

A substrate holding apparatus includes a case (10) having a case body (11) and a case cover (12), a plurality of substrates (13, 14, 15) held in the case (10) in a thickness direction of the substrates (13, 14, 15), and a plurality of support portions (21, 22, 23) formed at the case body (11), the plurality of support portions (21, 22, 23) constituting a plurality of support portion groups, the support portions (21, 22, 23) including end surfaces (21a, 22a, 23a) whose heights in the thickness direction are the same in each of the plurality of support portion groups, the heights of the end surfaces (21 a, 22a, 23a) of the support portions (21, 22, 23) in one of the plurality of support portion groups being different from the heights of the end surfaces (21 a, 22a, 23a) of the support portions (21, 22, 23) in the other of the plurality of support portion groups, one of the substrates (13) including a peripheral edge portion having guide grooves (13c) into which the support portions (23) in one of the plurality of support portion groups are inserted.

## Description

### TECHNICAL FIELD

This disclosure relates to a substrate holding apparatus for accommodating and holding a substrate in a case.

### BACKGROUND DISCUSSION

A known substrate holding apparatus is disclosed in JP1997-74219A (hereinafter referred to as Reference 1) includes a case formed by a case cover and a case body, and a substrate fixed in the case. Supporting portions (fitting slits) support both sides of the substrate are arranged at both sides of an inner portion of the case body in a direction where the substrate is slid from an opening to the inner portion of the case body so as to be accommodated therewithin (the direction will be hereinafter referred to as a substrate inserting direction). Pressing portions extending in the substrate inserting direction are provided at a bottom surface of the case body and at the case cover, respectively. The substrate is pressed and deformed by the pressing portions in a condition where the case cover is fitted to the case body. Accordingly, the substrate is pressed to the supporting portions, therefore being fixed to the case.

A known substrate holding apparatus disclosed in JP2000-49475A (hereinafter referred to as Reference 2) includes a case formed by a case cover and a case body, and a substrate positioned and fixed in the case. The case body includes substrate guiding grooves. The case cover is fixed to the case body.

According to the substrate holding apparatus described in Reference 1, for example, in the case where a plurality of substrates is accommodated in the case, the substrates are electrically connected to one another before being accommodated within the case. Such procedures may be inappropriate for the substrates, therefore causing difficulty in accommodating the substrates in the case. Further, an electronic component mounted on each of the substrates generally protrudes from a surface of the substrate. Consequently, when the substrate is slid into the case in a direction along the surface of the substrate (in the substrate inserting direction) and accommodated in the case, the case requires a sufficient space over a whole range of a movement of the electronic component for preventing the electronic component protruding from the surface of the substrate, from interfering with an inner portion of the case. As a result, the size of the case is increased, therefore increasing the size of the substrate holding apparatus.

Meanwhile, according to the substrate holding apparatus described in Reference 2, when a plurality of substrates is positioned and fixed within the case, distances between the substrates are determined by distances between substrate guiding grooves for the substrates, respectively. Accordingly, a reduction of the distances between the substrates is restricted by a condition of a mold used for molding the case (the condition is the strength of the mold and the like). Further, the case requires a sufficient space for moving the substrates in a direction along a surface of each of the substrates into the case and for accommodating the substrates in the case.

A need thus exists for a substrate holding apparatus including a case, the size of which may be reduced while not being affected by a condition of a mold for molding the case and by a movement of an electronic component when the substrate is slid in the case.

### SUMMARY

According to an aspect of this disclosure, a substrate holding apparatus includes a case including a case body formed in a tubular shape that has a bottom surface and a case cover covering an end of an opening of the case body, a plurality of substrates at which electric circuits are mounted, the plurality of substrates being accommodated and held in the case in an overlapping manner with one another in a thickness direction of the plurality of substrates along a direction of the opening of the case body, and a plurality of support portions formed at an inner wall surface of the case body in a projecting manner in a column shape and extending in the thickness direction of the plurality of substrates, the plurality of support portions constituting a plurality of support portion groups, the plurality of support portions including end surfaces of which heights from the bottom surface of the case body in the thickness direction are the same as one another in each of the plurality of support portion groups, the heights of the end surfaces of the support portions in one of the plurality of support portion groups being different from the heights of the end surfaces of the support portions in the other of the plurality of support portion groups, one of the plurality of substrates including a peripheral edge portion formed by guide grooves into which the support portions in one of the plurality of support portion groups are inserted in the thickness direction, the heights of the end surfaces of the support portions in the one of the plurality of support portion groups being greater than the heights of the end surfaces of the support portions in the other of the plurality of support portion groups, the one of the plurality of substrates being supported by the end surfaces of the support portions in the other of the plurality of support portion groups, the heights of the end surfaces of the support portions in the other of the plurality of support portion groups being smaller than the heights of the end surfaces of the support portions in the one of the plurality of support portion groups.

As described above, the plurality of substrates is accommodated within the case while being positioned at the predetermined intervals of distances corresponding to the difference between the heights of the end surfaces of the support portions in one of the plurality of support portion groups and the other of the plurality of support portion groups. Further, when being accommodated within the case as described above, the substrates are overlapped with one another in the thickness direction corresponding to the direction of the opening of the case body. Furthermore, the electric circuits mounted on the substrates, respectively, are dislocated from one another thereon in the thickness direction so as to be prevented from interfering with one another (overlapping one another) between the substrates. Accordingly, the substrates may be accommodated within the case while not being affected by a movement of the electric circuits when the substrates are slid in the case along the thickness direction; therefore, the size of the case (case body) is prevented from being increased. Moreover, the support portions (support portion groups) are configured to extend in the thickness direction and to support the peripheral edge portions of the substrates on the end surfaces. Accordingly, the distance between the substrates is determined by the difference between the heights of the end surfaces of the support portions in one of the plurality of support portion groups and the other of the plurality of support portion groups the support portions. Further, the distance between the substrates is not determined by the sizes of areas of the end surfaces of the support portions. Consequently, the distance between the substrates may be reduced while not being restricted by conditions of a mold for molding the support portions.

According to another aspect of the disclosure, connector portions are formed to project at respective facing surfaces of the substrates arranged adjacent to each other in the thickness direction. The connector portions are fitted to each other in a case where one of the substrates is arranged in an overlapping manner relative to the other of the substrates in the thickness direction so that the substrates are electrically connected to each other.

Thus, one of the substrates supported by the end surfaces of the support portion and arranged adjacent to the other of the substrates in the thickness direction are fixed to each other.

According to a further aspect of the disclosure, one of the plurality of substrates facing the case cover includes a peripheral edge portion that is supported and positioned between the end surfaces of the support portions in one of the plurality of support portion groups and a facing surface of the case cover. The height of the end surfaces of the support portions in the one of the plurality of support portion groups is greatest among the plurality of support portion groups.

Accordingly, the one of the plurality of substrates facing the case cover is firmly fixed to the case body.

According to a still further aspect of the disclosure, the case is a case for a camera in which the plurality of substrates are accommodated and held in the case body and at least a lens is mounted at the case cover.

Accordingly, the vehicle camera in which the size of the case is further reduced may be provided without restriction due to a condition of a mold for molding the case and by the movement of the electric circuits when the substrates are slid in the case along the thickness direction.

### BRIEF DESCRIPTION OF THE DRAWINGS

The foregoing and additional features and characteristics of this disclosure will become more apparent from the following detailed description considered with the reference to the accompanying drawings, wherein:

Fig. 1 is an exploded perspective view illustrating a substrate holding apparatus; and

Fig. 2 is an exploded planar view illustrating the substrate holding apparatus.

### DETAILED DESCRIPTION

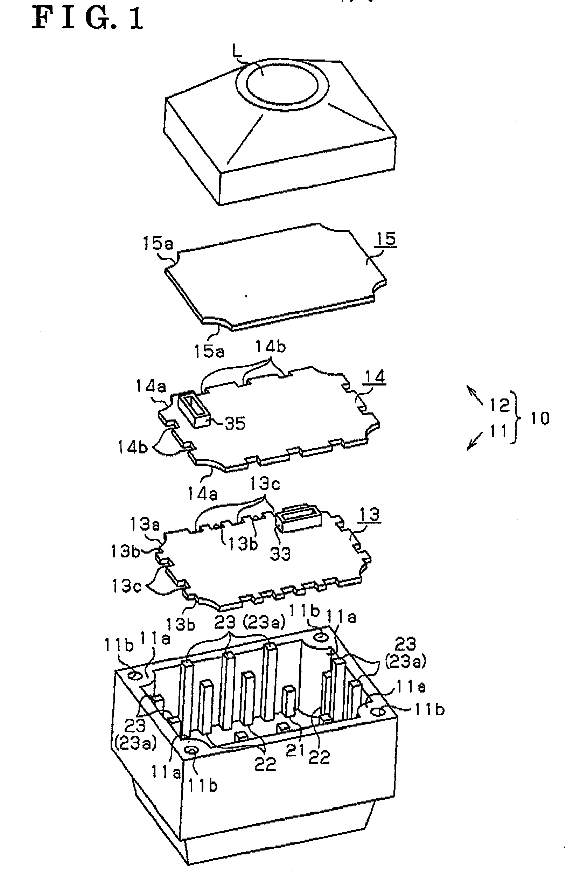

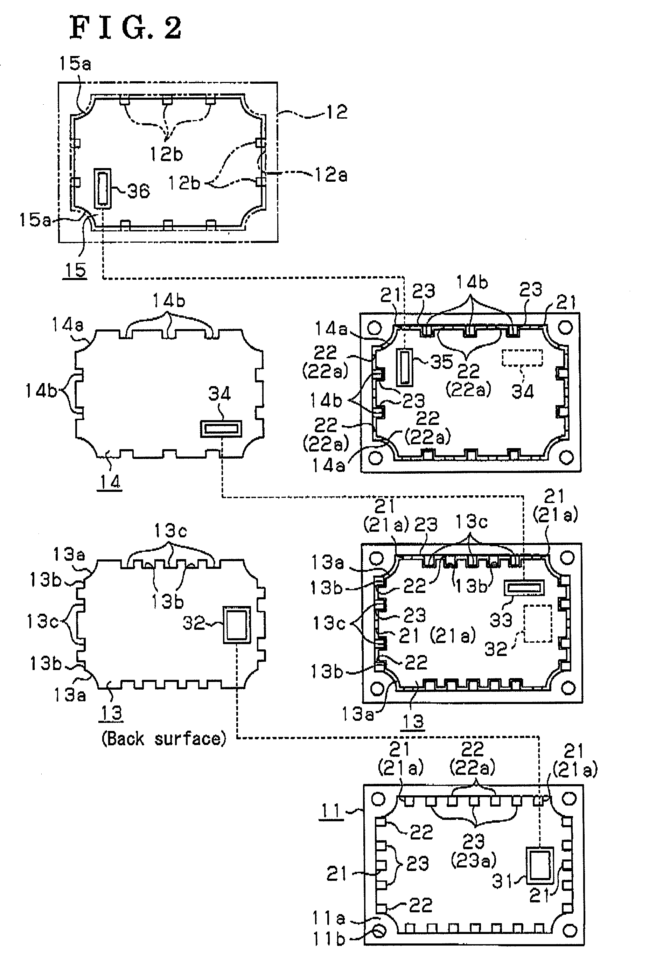

An embodiment of a substrate holding apparatus will be described hereinafter with reference to the attached drawings. Figs. 1 and 2 are exploded perspective and planar views, respectively, illustrating a vehicle camera (camera) on which the substrate holding apparatus according to the embodiment is mounted. As shown in Fig. 1, the vehicle camera includes a case 10 formed by a case body 11 and a case cover 12, and first, second, and third substrates 13, 14, and 15. Electric circuits (electronic components) are mounted on the first, second, and third substrates 13, 14, and 15, respectively.

The case body 11 is formed into an approximately square-shaped tube having a bottom surface. The case body 11 includes four connecting walls 11 a arranged at corners of an inner wall of the case body 11. The connecting walls 11a are integrally formed with the case body 11 in a projecting manner while extending in the direction of an opening of the case body 11 (the direction of the opening of the case body 11 corresponds to a vertical direction seen in Fig. 1 and thickness directions of the first, second, and third substrates 13, 14, and 15). Each of the connecting walls 11a has an approximate half-cylindrical shape. A bolt insertion hole 11 b is formed in the center of the connecting wall 11 a along a direction where the connecting wall 11 a extends. The case body 11 is formed by a resin or aluminum material.

The case body 11 includes a plurality of first support portions 21, a plurality of second support portions 22, and a plurality of third support portions 23. Each of the first, second, and third support portions 21, 22, and 23 serves as a support portion integrally formed with the case body 11. The support portion is formed in an approximate square-shaped (column-shaped) pole and in a projecting manner while extending along the direction of the opening of the case body 11. Upper end surfaces 21 a, 22a, and 23a of the first, second, and third support portions 21, 22, and 23 facing toward the direction of the opening of the case body 11 and serving as end surfaces have predetermined heights from the bottom surface of the case body 11. The first, second, and third support portions 21, 22, and 23 are stepped while having different heights from one another. That is, the heights of the upper end surfaces 21a, 22a, and 23a from the bottom surface of the case body 11 are designed to gradually increase in the aforementioned order. In addition, the third support portion 23 protrudes slightly outward from an end of the opening of the case body 11 in the vertical direction seen in Fig. 1.

As illustrated in Fig. 2, two first support portions 21 are arranged at both end portions of each of long sides of a rectangle of the case body 11 and one first support portion 21 is arranged at an intermediate portion of each of short sides of the rectangle of the case body 11. That is, a total of six first support portions 21 as a group is provided at the case body 11 so as to form a first support portion group (support portion group). Two second support portions 22 are arranged at an intermediate portion of each of the long sides of the rectangle of the case body 11 so as to be positioned at an approximate central portion between the first support portions 21 a arranged at the both end portions of the long side of the rectangle. Further, two second support portions 22 are arranged at both end portions of each of the short sides of the rectangle of the case body 11. That is, a total of eight second support portions 22 as a group is provided at the case body 11 so as to form a second support portion group (support portion group). In addition, three third support portions 23 are arranged at each of the long sides of the rectangle of the case body 11. Two of the aforementioned three third support portions 23 are positioned in the approximate central portions, respectively, between the first and second support portions 21 and 22 that are located adjacent to each other at the long side of the rectangle of the case body 11. Further, the rest of the aforementioned three third support portions 23 is positioned at an approximate central portion between the second support portions 22 that are arranged at the intermediate portion of the long side of the rectangle of the case body 11. Further, two third support portions 23 are arranged at each of the short sides of the rectangle of the case body 11. The aforementioned two third support portions 23 are positioned approximately at approximate central portions, respectively, between the first and second support portions 21 and 22 that are adjacent to each other at the short side of the rectangle of the case body 11. That is, a total of ten third support portions 23 as a group is provided at the case body 11 so as to form a third support portion group (support portion group). As described above, the number of the first, second, and third support portions 21, 22, and 23 is set to increase in the described order as the heights of the upper end surfaces 21 a, 22a, and 23a from the bottom surface of the case body 11 increase in the described order. In addition, a body-side connector portion 31 is provided at one side (right side in Fig. 2) of the bottom surface of the case body 11 in a longitudinal direction of the case body 11. A cable led from the body-side connector portion 31 to an outer side of the case 10 is electrically connected to a peripheral device (for example, a monitor and the like) or to a power source (battery). Further, the body-side connector portion 31 is directly attached to the first substrate 13 so as to be electrically connected thereto.

The first substrate 13 is formed into an approximate rectangular plate as seen in a plan view so as to conform to an outer shape of the inner wall of the case body 11, which is seen in a plan view. Four notched portions 13a notched into curved shapes are formed at corners of the rectangular plate of the first substrate 13 so as to prevent from interfering with the connecting walls 11a. A plurality of guide grooves (eight guide grooves) 13b having approximate square shapes is formed at a peripheral edge portion of the first substrate 13. All of the second support portions 22 (second support portion group) is inserted in the guide grooves 13b along a longitudinal direction of the second support portion group (along the thickness direction of the first substrate 13). A plurality of guide grooves (ten guide grooves) 13c having approximate square shapes is formed at the peripheral edge portion of the first substrate 13. All of the third support portions 23 (third support portion group) is inserted in the guide grooves 13c along a longitudinal direction of the third support portion group (along the thickness direction of the first substrate 13). Thus, when the first substrate 13 is accommodated within the case body 11 along the direction of the opening of the case body 11 while the second and third support portions 22 and 23 are inserted in the respective guide grooves 13b and 13c, the peripheral edge portion of the first substrate 13 is in contact only with the upper end surfaces 21a of the first support portions 21 so as to be supported thereby. That is, the first substrate 13 is accommodated in the case body 11 while being positioned at the lowest height from the bottom surface of the case body 11.

As shown in Fig. 2, a back-surface connector portion 32 is provided at an end portion (right side in Fig. 2) in a longitudinal direction of the first substrate 13. The back-surface connector portion 32 protrudes from the back surface of the first substrate 13 so as to face the body-side connector portion 31. When the first substrate 13 is accommodated within the case body 11 along the direction of the opening of the case body 11, the back-surface connector portion 32 is fitted to the body-side connector portion 31; thereby, the first substrate 13 is fixed to the case body 11 and positioned on the first support portions 21 (upper end surfaces 21 a) at the same time as being electrically connected to the peripheral device. A power supply circuit supplying an electric power to the second and third substrates 14 and 15 is mounted on the first substrate 13. In addition, an upper-surface connector portion 33 directly and electrically connected to the second substrate 14 is arranged at an end surface of the first substrate 13, which faces toward the direction of the opening of the case body 11 (the end surface is an upper surface of the first substrate 13). The upper-surface connector portion 33 is positioned at one of the corners on the upper surface of the first substrate 13 (at an upper right side on the upper surface seen in Fig. 2) so as not to overlap the back-surface connector portion 32 and the body-side connector portion 31 in the thickness direction.

The second substrate 14 is formed in an approximate rectangular plate as seen in a plan view so as to conform to the outer shape of the inner wall of the case body 11 seen in a plan view. Four notched portions 14a notched into curved shapes are formed at corners of the rectangular plate of the second substrate 14 so as to prevent from interfering with the connecting walls 11a. A plurality of guide grooves (ten guide grooves) 14b having approximate square shapes is formed at a peripheral edge portion of the second substrate 14. All of the third support portions 23 (third support portion group) is inserted in the guide grooves 14b along the longitudinal direction of the third support portion group (along the thickness direction of the second substrate 14). Thus, when the second substrate 14 is accommodated within the case body 11 along the direction of the opening of the case body 11 while the third support portions 23 are inserted in the guide grooves 14b, the peripheral edge portion of the second substrate 14 is in contact only with the upper end surfaces 22a of the second support portions 22 (second support portion group) so as to be supported thereby. That is, the second substrate 14 is accommodated in the case body 11 while being positioned at an intermediate height from the bottom surface of the case body 11. A distance between the first and second substrates 13 and 14 in the thickness direction is determined by a difference between the heights of the upper surfaces 21 a and 22a of the first and second support portions 21 and 22.

As shown in Fig. 2, a back-surface connector portion 34 is provided at one of the corners on a back surface of the second substrate 14 (at a lower right side on the back surface as seen in Fig. 2). The back-surface connector portion 34 protrudes from the back surface of the second substrate 14 so as to face the upper-surface connector portion 33. When the second substrate 14 is accommodated within the case body 11 along the direction of the opening of the case body 11, the back-surface connector portion 34 is fitted to the upper-surface connector portion 33; thereby, the second substrate 14 is fixed to the first substrate 13 on the second support portions 22 (upper end surfaces 22a) at the same time as being electrically connected to the first substrate 13. An image processing circuit processing an image signal (for example, an NTSC signal) output from the third substrate 15 is mounted on the second substrate 14. In addition, an upper-surface connector portion 35 directly and electrically connected to the third substrate 15 is arranged at an end surface of the second substrate 14, which faces toward the direction of the opening of the case body 11 (the end surface is an upper surface of the second substrate 14). The upper-surface connector portion 35 is positioned at one of the corners on the upper surface of the second substrate 14 (at an upper left side on the upper surface seen in Fig. 2) so as not to overlap the back-surface connector portion 32, the upper-surface connector portion 33, the back-surface connector portion 34, and the body-side connector portion 31 in the thickness direction.

The third substrate 15 is formed in an approximate rectangular plate as seen in a plan view so as to conform to the outer shape of the inner wall of the case body 11 seen in a plan view. Four notched portions 15a, each notched into a curved shape, are formed at corners of the rectangular plate of the third substrate 15 so as to prevent from interfering with the connecting walls 11a. The third substrate 15 is fixed to the case cover 12; therefore, for example, when the end of the opening of the case body 11 is closed by the case cover 12, a peripheral edge portion of the third substrate 15 is in contact with the upper end surfaces 23a of the third support portions 23 (third support portion group) so as to be supported thereby.

In particular, the case cover 12 includes a recessed portion 12a formed in an approximate square shape as seen from the bottom surface of the case body 11. The recessed portion 12a has an outer shape that is approximately the same size as the outer shape of the inner wall of the case body 11 seen in a plan view. The case cover 12 further includes a plurality of pressing portions 12b. The pressing portions 12b are formed on a surface (inner wall surface) of an inner wall of the case cover 12 so as to horizontally protrude toward an inner side of the case cover 12 as seen in Fig. 2. The pressing portions 12b formed in approximate square-shaped poles face the third support portions 23 (third support portion group) in a direction where the case cover 12 is attached to the case body 11. When the case cover 12 is attached to the case body 11, the peripheral edge portion of the third substrate 15 is positioned and supported between facing surfaces of the pressing portions 12b, which face the peripheral edge portion, and the upper end surfaces 23a of the third support portions 23 facing the peripheral edge portion. As a result, the third substrate 15 is further firmly fixed to the case body 11 (case 10). Further, the third substrate 15 is accommodated within the case 10 (case cover 12) so as to be positioned at the highest level in the vertical direction in Fig. 1 while protruding slightly outward from the end of the opening of the case body 11 in the vertical direction. A distance between the second and third substrates 14 and 15 in the thickness direction is determined by a difference between the heights of the upper surfaces 22a and 23a of the second and third support portions 22 and 23. Thread portions of bolts inserted into the bolt insertion holes 11b are fastened to nut portions embedded or pierced in the case cover 12; thereby, the case cover 12 is fixed to the case body 11.

As shown in Fig. 2, a back-surface connector portion 36 is provided at one of the corners on a back surface of the third substrate 15 (at a lower left side on the back surface as seen in Fig. 2). The back-surface connector portion 36 protrudes from the back surface of the third substrate 15 so as to face the upper-surface connector portion 35. When the case cover 12 is attached to the case body 11, the back-surface connector portion 36 is fitted to the upper-surface connector portion 35; thereby the third substrate 15 is further firmly fixed to the case body 11 on the third support portions 23 (upper end surfaces 23a) at the same time as being electrically connected to the second substrate 14. An image pickup device is mounted on the third substrate 15. The image pickup device is formed, for example, by CMOS or CCD. Light irradiated through a lens L attached to the case cover 12 (see Fig. 1) is converted to an image signal by the image pickup device mounted on the third substrate 15. Then, the image signal is output from the third substrate 15 to the second substrate 14.

In addition, the electric circuits arranged on facing walls of the first and second substrates 13 and 14, respectively, and between facing walls of the second and third substrates 14 and 15, respectively, are dislocated from one another so as not to overlap one another in the thickness direction in a condition where the first, second, and third substrates 13, 14, and 15 are provided adjacent to one another in the vertical direction (thickness direction). Such arrangement of the electric circuits is intended to secure distances required for arranging the electric circuits between the first and second substrates 13 and 14 and between the second and third substrates 14 and 15 in the thickness direction and to prevent increase of the distances in the thickness direction.

Assembling steps of the substrate holding apparatus according to the embodiment will be briefly explained as follows. First, while the second and third support portions 22 and 23 are being inserted in the respective guide grooves 13b and 13c of the first substrate 13, the first substrate 13 is accommodated in the case body 11 along the direction of the opening of the case body 11 until the peripheral edge portion of the first substrate 13 is supported by the upper end surfaces 21 a of the first support portions 21 in contact therewith. At this time, the back-surface connector portion 32 is fitted to the body-side connector portion 31; thereby, the first substrate 13 is fixed to the case body 11 and positioned on the first support portions 21 (upper end surfaces 21 a) in the thickness direction at the same time as electrically connected to the peripheral device. In addition, the position of the first substrate 13 is determined in such a way that the second and third support portions 22 and 23 are respectively inserted in the guide grooves 13b and 13c.

Next, while the third support portions 23 are inserted in the guide grooves 14b of the second substrate 14, the second substrate 14 is accommodated in the case body 11 along the direction of the opening of the case body 11 until the peripheral edge portion of the second substrate 14 is supported by the upper end surfaces 22a of the second support portions 22 in contact therewith. At this time, the back-surface connector portion 34 is fitted to the upper-surface connector portion 33; thereby, the second substrate 14 is fixed to the first substrate 13 and positioned on the second support portions 22 (upper end surfaces 22a) in the thickness direction at the same time as being electrically connected to the first substrate 13. In addition, the position of the second substrate 14 is determined in such a way that the third support portions 23 are inserted in the guide grooves 14b.

Then, the case cover 12 is fixed to the case body 11 in such a way that the end of the opening of the case body 11 is closed by the case cover 12 to which the third substrate 15 is fixed. At this time, the peripheral edge portion of the third substrate 15 that is in contact with the upper end surfaces 23a in the thickness direction is positioned between the facing surfaces of the pressing portions 12b facing the peripheral edge portion, and the upper end surfaces 23a of the third support portions 23 facing the peripheral edge portion. As a result, the third substrate 15 is firmly fixed to the case body 11. Further, the back-surface connector portion 36 is fitted to the upper-surface connector portion 35; thereby, the third substrate 15 is further firmly fixed to the second substrate 14 on the third support portions 23 (upper end surfaces 23a) in the thickness direction at the same time as being electrically connected the second substrate 14.

As described above, the first, second, and third substrates 13, 14, and 15 are overlapped in the thickness direction while being arranged at intervals of the distances corresponding to the difference between the heights of the first and second substrates 13 and 14 and to the difference between the heights of the second and third substrates 14 and 15. Thus, the first, second, and third substrates 13, 14, and 15 are accommodated within the case 10 (case body 11). According to such configuration, the light irradiated through the lens L attached to the case cover 12 is converted to the image signal by the third substrate 15 (image pickup device). Then, the image signal converted by the image pickup device is output from the third substrate 15 to the second substrate 14. The image signal outputted from the third substrate 15 is processed by the image processing circuit mounted on the second substrate 14 and thereafter is outputted from the second substrate 14 via the first substrate 13 to the peripheral device. At this time, the electric power is applied to the second and third substrates 14 and 15 by the first substrate 13 (power supply circuit).

In addition, the aforementioned embodiment may be modified as follows. The height of the upper end surfaces 23a of the third support portions 23 may be set so that the third support portions 23 are accommodated within the case body 11 without protruding outward from the end of the opening of the case body 11 in the vertical direction, In this case, an area of an opening of the recessed portion 12a may be reduced; thereby, the peripheral edge portion of the third substrate 15 is positioned and supported between an end of an opening of the case cover 12 and the upper end surfaces 23a of the third support portions 23 to therefore fix the third substrate 15 to the case body 11.

The first, second, and third support portions 21, 22, and 23 may have circular cylindrical shapes or other shapes as long as being formed in column shapes. Moreover, the thickness direction of the first, second, and third substrates 13, 14, and 15, where the first, second, and third support portions 21, 22, and 23 extend, (the direction of the opening of the case body 11) does not need to be completely perpendicular to the first, second, and third substrates 13, 14, and 15.

The case body 11 may have a circular cylindrical shape or other shapes as long as being formed into a tubular member having a bottom surface. That is, the case body 11 may be modified as long as including column-shaped supporting portions that are arranged at the inner wall and that support the first, second, and third substrates 13, 14, and 15. In this case, outer shapes of the first, second, and third substrates are not necessarily formed so as to conform to the outer shape of the inner wall of the case body 11 seen in a plan view. In addition, when a plurality of support portions including upper end surfaces having the same height are arranged at the inner wall of the case body 11, each of the support portions is necessarily formed in a projecting manner from the inner wall of the case body 11 so as to support the first, second, and third substrates 13, 14, and 15.

In the embodiment, spacers may be appropriately provided to be supported between the first and second substrates 13 and 14 arranged adjacent to each other in the thickness direction and between the second and third substrates 14 and 15 arranged adjacent to each other in the thickness direction. Moreover, the number of substrates to be accommodated within the case 10 may be two, four or more than four substrates.

In addition, the substrate holding apparatus according to the embodiment may be applied to electric equipments other than the vehicle camera. Moreover, the substrate holding apparatus according to the embodiment may be modified as follows. The substrate holding apparatus may be formed by the first substrate 13 on which the image pickup device is mounted, the second substrate 14 on which the image processing circuit is mounted, and the third substrate 15 on which the power supply circuit is mounted. The image signal output from the image pickup device mounted on the first substrate 13 is processed by the image processing circuit mounted on the second substrate 14. The power supply circuit mounted on the third substrate 15 supplies the electric power to the first and second substrates 13 and 14. According to the configuration of the substrate holding apparatus, various electric circuits required for the vehicle camera may be integrally accommodated within the case 10. In particular, the image signal is processed within the case 10 (by the image processing circuit mounted on the second substrate 14); thereby, the image signal may be output directly to a monitor and the like while not being out put to an additional processing circuit.
A substrate holding apparatus includes a case (10) having a case body (11) and a case cover (12), a plurality of substrates (13, 14, 15) held in the case (10) in a thickness direction of the substrates (13, 14, 15), and a plurality of support portions (21, 22, 23) formed at the case body (11), the plurality of support portions (21, 22, 23) constituting a plurality of support portion groups, the support portions (21, 22, 23) including end surfaces (21 a, 22a, 23a) whose heights in the thickness direction are the same in each of the plurality of support portion groups, the heights of the end surfaces (21 a, 22a, 23a) of the support portions (21, 22, 23) in one of the plurality of support portion groups being different from the heights of the end surfaces (21a, 22a, 23a) of the support portions (21, 22, 23) in the other of the plurality of support portion groups, one of the substrates (13) including a peripheral edge portion having guide grooves (13c) into which the support portions (23) in one of the plurality of support portion groups are inserted.

## Claims

1. A substrate holding apparatus comprising:
a case (10) including a case body (11) formed in a tubular shape that has a bottom surface and a case cover (12) covering an end of an opening of the case body (11);
a plurality of substrates (13, 14, 15) at which electric circuits are mounted, the plurality of substrates (13, 14, 15) being accommodated and held in the case (10) in an overlapping manner with one another in a thickness direction of the plurality of substrates (13, 14, 15) along a direction of the opening of the case body (11); and
a plurality of support portions (21, 22, 23) formed at an inner wall surface of the case body (11) in a projecting manner in a column shape and extending in the thickness direction of the plurality of substrates (13, 14, 15),
the plurality of support portions (21, 22, 23) constituting a plurality of support portion groups, the plurality of support portions (21, 22, 23) including end surfaces (21 a, 22a, 23a) of which heights in the thickness direction are the same as one another in each of the plurality of support portion groups, the heights of the end surfaces (21 a, 22a, 23a) of the support portions (21, 22, 23) in one of the plurality of support portion groups being different from the heights of the end surfaces (21 a, 22a, 23a) of the support portions (21, 22, 23) in the other of the plurality of support portion groups,
one of the plurality of substrates (13) including a peripheral edge portion formed by guide grooves (13c) into which the support portions (23) in one of the plurality of support portion groups are inserted in the thickness direction, the heights of the end surfaces (23a) of the support portions (23) in the one of the plurality of support portion groups being greater than the heights of the end surfaces (21 a, 22a) of the support portions (21, 22) in the other of the plurality of support portion groups, the one of the plurality of substrates (13) being supported by the end surfaces (21a) of the support portions (21) in the other of the plurality of support portion groups, the heights of the end surfaces (21a) of the support portions (21) in the other of the plurality of support portion groups being smaller than the heights of the end surfaces (22a, 23a) of the support portions (22, 23) in the one of the plurality of support portion groups.

2. The substrate holding apparatus according to claim 1, wherein connector portions (33, 34, 35, 36) are formed to project at respective facing surfaces of the substrates (13, 14, 15) arranged adjacent to each other in the thickness direction, and the connector portions (33, 34, 35, 36) are fitted to each other in a case where one of the substrates (13, 14, 15) is arranged in an overlapping manner relative to the other of the substrates (13, 14, 15) in the thickness direction so that the substrates (13, 14, 15) are electrically connected to each other.

3. The substrate holding apparatus according to claim 1 or 2, wherein one of the plurality of substrates (15) facing the case cover (12) includes a peripheral edge portion that is supported and positioned between the end surfaces (23a) of the support portions (23) in one of the plurality of support portion groups and a facing surface of the case cover (12), the heights of the end surfaces (23a) of the support portions (23) in the one of the plurality of support portion groups being greatest among the plurality of support portion groups.

4. The substrate holding apparatus according to any one of claims 1 through 3, wherein the case (10) is a case for a camera in which the plurality of substrates (13, 14, 15) are accommodated and held in the case body (11) and at least a lens (L) is mounted at the case cover (12).
